# EUROPÄISCHE PATENTANMELDUNG

(11) **EP 4 730 584 A1**
(43) Veröffentlichungstag der Anmeldung: **22.04.2026**
(21) Anmeldenummer: 25206066.0
(22) Anmeldetag: 01.10.2025
(51) Int. Cl.: H02H 3/087, H02H 3/093, H02H 3/18

(54) **SCHUTZSCHALTER**

(30) Priorität: 16.10.2024 DE 102024210036
(71) Anmelder: Ellenberger & Poensgen GmbH, 90518 Altdorf (DE)
(72) Erfinder: KÖPF, Hendrik-Christian, 90480 Nürnberg (DE); LABS, Alexander, 90610 Winkelhaid (DE)
(74) Vertreter: FDST Patentanwälte

(57) **Zusammenfassung**

Die Erfindung betrifft einen Schutzschalter (10) mit zwei Anschlüssen (12), zwischen denen ein Strompfad (14) gebildet ist, dem eine Einheit (32) zum richtungsabhängigen Ermitteln eines mittels des Strompfads (14) geführten elektrischen Stroms zugeordnet ist. Der Strompfad (14) weist einen ersten Zweig (22) mit zwei elektrisch in Reihe und gegengesetzt zueinander geschalteten Halbleiterschalter (26) auf, die jeweils einen Steuereingang (30) umfassen und mittels einer Steuereinheit (36) entsprechend einer Zeit-Strom-Auslösekennlinie (38) betrieben sind. Mittels der Zeit-Strom-Auslösekennlinie (38) sind für unterschiedliche Stromstärken (40) zumindest teilweise sich unterscheidende Zeitdauern (42) angegeben, ab der ein Unterbrechen des Strompfads (14) erfolgt, und wobei sich zumindest einige der Zeitdauern (42) für unterschiedliche Stromrichtungen unterscheiden. Ferner betrifft die Erfindung die Verwendung eines Schutzschalters (10).

## Beschreibung

Die Erfindung betrifft einen Schutzschalter sowie die Verwendung eines Schutzschalters. Der Schutzschalter weist zwei Anschlüsse auf, zwischen denen ein Strompfad gebildet ist.

Industrieanlagen weisen üblicherweise mehrere Aktoren auf, mittels derer eine Erstellung und/oder Bearbeitung von Werkstücken erfolgt. Die Aktoren selbst umfassen meist einen Elektromotor, der mittels eines Umrichters bestromt wird. Zumindest werden die Aktoren meist mittels eines elektrischen Stroms betrieben. Zur vereinfachten Verschaltung sind die einzelnen Aktoren, insbesondere die Umrichter, zueinander parallelgeschaltet und mittels eines gemeinsamen Gleichspannungszwischenkreises gespeist. Üblicherweise wird mittels des Gleichspannungszwischenkreises eine Gleichspannung zwischen 400 V und 650 V geführt, und dieser wird mittels einer Gleichspannungsquelle gespeist, beispielsweise einem Gleichrichter, der an ein Versorgungsnetz angeschlossen ist.

Da die Aktoren unterschiedlich betätigt werden, ist dabei die dem Gleichspannungszwischenkreis entnommene Energiemenge zeitlich variabel, was zu Schwankungen in der an dem Gleichspannungszwischenkreises anliegenden elektrischen Spannung führt. Damit der Betrieb des jeweiligen Aktors davon nicht beeinflusst wird, weist jeder Umrichter meist einen Energiespeicher in Form eines Kondensators auf, mittels dessen eine Stabilisierung der jeweils verwendeten elektrischen Spannung erfolgt.

Damit im Fehlerfall eines Aktors, beispielsweise bei einem Kurzschluss des Elektromotors oder des Umrichters, eine weitere Beschädigung des jeweiligen Aktors oder der Umgebung, beispielsweise aufgrund eines entstehenden Brandes, unterbleibt, ist jeder Aktor üblicherweise mittels eines Schutzschalters mit dem Gleichspannungszwischenkreis elektrisch verbunden. Mittels des Schutzschalters wird dabei der zu dem jeweiligen Aktor geführte elektrische Strom überwacht, und falls dieser einen bestimmten Schwellwert überschreitet, wird ein Schalter des Schutzschalters betätigt, sodass der Stromfluss zu dem Aktor unterbrochen wird.

Bei einem Kurzschluss bei einem der Aktoren ist es dabei möglich, dass der zu diesem Aktor fließende elektrische Strom nicht lediglich von der Gleichspannungsquelle bereitgestellt wird, sondern dass auch ein Energiespeicher eines hierzu parallelgeschalteten Aktors geleert wird. Aufgrund der niederohmigen Verbindung bei dem defekten Aktor fließt somit von dem Energiespeicher des parallelgeschalteten Aktors ein vergleichsweise großer elektrischer Strom zurück in den Gleichspannungszwischenkreises und von dort zu dem defekten Aktor, zumindest bis der defekte Aktor von dem Gleichspannungszwischenkreis elektrisch getrennt wird. Bis dahin wird jedoch der erhöhte elektrische Strom von dem Energiespeicher des parallelgeschalteten Aktors in den Gleichspannungszwischenkreises mittels des diesem Aktor zugeordneten Schutzschalters geführt. Je nach verwendetem Schutzschalter ist es dabei möglich, dass aufgrund des erhöhten elektrischen Stroms der Schutzschalter betätigt wird, sodass der parallelgeschaltete Aktor von dem Gleichspannungszwischenkreis getrennt wird, obwohl dieser Aktor keine Fehlfunktion aufweist. Somit erfolgt ein nicht erforderlicher Ausfall dieses Aktors, weswegen Betriebskosten der Industrieanlage erhöht sind.

Aus US 2,693,566 A ist ein Röhrengleichrichter bekannt. Zur Verhinderung einer Beschädigung der Röhre sind davor zwei Dioden antiparallel zueinander und in Reihe zu der Röhre geschaltet. Bei der entgegen der Stromdurchlassrichtung der Röhre verschalteten Diode ist ein Widerstand elektrisch in Reihe geschaltet. Im Normalbetrieb ist die über den Widerstand anfallende elektrischen Spannung vergleichsweise gering. Falls jedoch aufgrund einer Fehlfunktion der Röhre ein Rückstrom auftritt, fällt über den Widerstand eine elektrische Spannung an. Infolgedessen wird ein hierzu parallel geschaltetes Relais betätigt, was zum Auslösen eines in Reihe zu der Röhre geschalteten Schalters führt.

Aus CH 214 712 A ist eine Anordnung zum Schutz von Gleichstromnetzen gegen Rückstrom bekannt. Ein Relais, mittels dessen ein Schalter betätigt wird, ist elektrisch in Reihe mit einer Diode geschaltet. Hierzu ist ein Widerstand parallelgeschaltet. Somit erfolgte die Bestromung des Relais entweder bei einem gewünschten Strom oder beim unerwünschten Strom, sodass die Betätigung des Schalters erfolgt.

Der Erfindung liegt die Aufgabe zugrunde, einen besonders geeigneten Schutzschalter sowie eine besonders geeignete Verwendung eines Schutzschalters anzugeben, wobei vorteilhafterweise eine Anzahl von nicht erforderlichen Auslösungen verringert und/oder eine Betriebssicherheit erhöht ist.

Hinsichtlich des Schutzschalters wird diese Aufgabe durch die Merkmale des Anspruchs 1 und hinsichtlich der Verwendung durch die Merkmale des Anspruchs 8 erfindungsgemäß gelöst. Vorteilhafte Weiterbildungen und Ausgestaltungen sind Gegenstand der jeweiligen Unteransprüche.

Der Schutzschalter dient insbesondere der Absicherung eines Geräts, und der Schutzschalter ist beispielsweise ein Geräteschutzschalter. Alternativ oder in Kombination hierzu dient der Schutzschalter der Absicherung einer Leitung und ist somit ein Leitungsschutzschalter. Zumindest ist vorzugsweise der Schutzschalter geeignet, insbesondere vorgesehen und eingerichtet, in einen Stromkreis eingebracht zu werden und bei einem Fehlerfall einen Stromfluss über diesen zu unterbrechen.

Der Schutzschalter umfasst zwei Anschlüsse, zwischen denen ein Strompfad gebildet ist. Bei Normalbetrieb wird mittels des Strompfads zwischen den beiden Anschlüssen ein elektrischer Strom geführt, sodass insbesondere eine Bestromung einer Last erfolgt, die an einen der Anschlüsse elektrisch angeschlossen ist. In diesem Fall ist der Schutzschalter geschlossen und folglich elektrisch leitend. In einem geöffneten Zustand hingegen, ist der Schutzschalter elektrisch nichtleitend, und der Strompfad ist insbesondere unterbrochen. Zumindest besteht keine niederohmige Verbindung, und beispielsweise ist dabei der Strompfad galvanisch getrennt.

Dem Strompfad ist eine Einheit zum Ermitteln eines mittels des Strompfads geführten elektrischen Stroms zugeordnet. Beispielsweise ist die Einheit ein Bestandteil des Strompfads oder zum Beispiel neben diesem angeordnet. Insbesondere ist es hierbei möglich, mittels der Einheit den geführten elektrischen Strom direkt zu messen. Alternativ hierzu wird dieser beispielsweise aus anderen Messdaten ermittelt, die wiederum zweckmäßigerweise mittels der Einheit gemessen werden. Das Ermitteln des geführten elektrischen Stroms erfolgt richtungsabhängig. Mit anderen Worten wird somit mittels der Einheit insbesondere die Höhe des elektrischen Stroms quantitativ ermittelt, als auch qualitativ, also in welche Stromrichtung der elektrische Strom fließt. Zusammenfassend wird somit für jede der Stromrechnungen die Höhe des elektrischen Stroms ermittelt. Hierfür wird beispielsweise der elektrische Strom vorzeichenbehaftet gemessen, wobei beispielsweise bei der einen Stromrichtung ein positives Vorzeichen und bei der anderen Stromrichtung ein negatives Vorzeichen verwendet wird. Zumindest ist anhand der Einheit ermittelbar, in welche Stromrichtung der elektrische Strom zwischen den Anschlüssen fließt, also von welchen der Anschlüsse zu welchem.

Der Strompfad weist einen ersten Zweig mit zwei Halbleiterschaltern auf. Diese sind elektrisch in Reihe geschaltet. Folglich wird der elektrische Strom, wenn dieser zwischen den beiden Anschlüssen fließt, über den ersten Zweig und somit mittels beider Halbleiterschalter geführt. Die Halbleiterschalter sind hierbei entgegengesetzt zueinander geschaltet. Infolgedessen ist es möglich, mittels der beiden Halbleiterschalter den elektrischen Strom in beide Stromrichtungen zu unterbrechen. Zweckmäßigerweise weist jeder der beiden Halbleiterschalter eine Freilaufdiode auf, was die Herstellung der Halbleiterschalter erleichtert und somit Bauteilkosten reduziert.

Zum Beispiel sind Halbleiterschalter zueinander unterschiedlich oder zweckmäßigerweise zueinander baugleich. Geeigneterweise wird als Halbleiterschalter jeweils ein Feldeffekttransistor verwendet, vorzugsweise ein MOSFET oder ein JFET. In einer weiteren Alternative wird zum Beispiel ein IGBT verwendet. Zumindest weist jeder der Schalter zwei Ausgänge auf, beispielsweise einen Kollektor und einen Emitter. Diese sind dem Strompfad zugeordnet, und beispielsweise sind die Kollektoren oder die Ermittler der beiden Halbleiterschalter miteinander kontaktiert, sodass sich zum Beispiel um eine "common source"- oder eine "common darin"-Verschaltung handelt. Die jeweils anderen Ausgänge sind gegen die Anschlüsse geführt, beispielsweise direkt oder über weitere Bauteile. Zudem weist jeder Halbleiterschalter einen Steuereingang auf, der insbesondere als Basis bezeichnet wird. Anhand einer an dem Steuereingang anliegenden elektrischen Spannung wird dabei insbesondere ein Schaltzustand des jeweiligen Halbleiterschalters bestimmt, also ob dieser elektrisch leitend oder elektrisch nichtleitend ist.

Die Halbleiterschalter sind mittels einer Steuereinheit betrieben. Hierfür sind insbesondere die Steuereingänge der Halbleiterschalter an die Steuereinheit angeschlossen. Die Steuereinheit ist hierbei beispielsweise mittels diskreter Bauteile aufgebaut und weist insbesondere eine Mehrzahl unterschiedlicher elektrischer Bauteile auf. Alternativ umfasst die Steuereinheit beispielsweise zumindest auch elektronische Bauteile, insbesondere einen Mikrocontroller. Die Steuereinheit ist zweckmäßigerweise signaltechnisch mit der Einheit verbunden, sodass mittels der Steuereinheit insbesondere auch der geführte elektrische Strom erfasst wird. Beispielsweise wird dabei mittels der Steuereinheit anhand der mittels der Einheit bereitgestellten Messdaten der elektrische Strom richtungsabhängig ermittelt. Mit anderen Worten erfolgt die Auswertung der Messdaten mittels der Steuereinheit, und die Messdaten werden mittels der Einheit bereitgestellt.

Die Halbleiterschalter sind dabei mittels der Steuereinheit entsprechend einer Zeit-Strom-Auslösekennlinie betrieben, die auch als Zeit-Strom-Kennlinie bezeichnet ist. Hierbei ist. Mittels der Zeit-Strom-Auslösekennlinie sind dabei für unterschiedliche Stromstärken zumindest teilweise sich unterscheidenden Zeitdauern angegeben. Folglich handelt es sich bei der Zeit-Strom-Auslösekennlinie um eine Tabelle, wobei für unterschiedlichen Stromstärken jeweils eine Zeitdauer angegeben ist. Zumindest einige der Zeitdauern unterscheiden sich dabei bei unterschiedlichen Stromstärken. Hierbei ist es jedoch auch möglich, dass bestimmten Stromstärken die gleiche Zeitdauer zugeordnet ist. Jedoch sind zumindest zwei Stromstärken, die nicht verschwinden sind, also die nicht 0 A betragen, jeweils eine Zeitdauer zugeordnet, die sich unterscheidenden. Die Stromstärke bezeichnet dabei insbesondere den Betrag des geführten elektrischen Stroms.

Fener unterscheiden sich einige der Zeitdauern, die der gleichen Stromstärke zugeordnet sind, in Abhängigkeit der Stromrichtung. Mit anderen Worten unterscheiden sich zumindest einige der Zeitdauern für unterschiedliche Stromrichtungen. Zusammenfassend sind somit mittels der Zeit-Strom-Auslösekennlinie für jede Stromrichtung zumindest zwei unterschiedliche Stromstärken angegeben, bei denen sich die Zeitdauern unterscheiden. Dabei unterscheiden sich auch die Zeitdauern bei den unterschiedlichen Stromrichtungen, weswegen somit zumindest vier unterschiedliche Zeitdauern vorhanden sind.

Wenn der elektrische Strom mit der entsprechenden Stromstärke für die zugeordnete Zeitdauer geführt wird, erfolgt ein Unterbrechen des Strompfads. Hierfür werden die Halbleiterschalter mittels der Steuereinheit entsprechend betrieben, vorzugsweise angesteuert. Zusammenfassend werden, wenn mittels des Strompfads der die Stromstärke aufweisende elektrische Strom für die zugeordnete Zeitdauer geführt wurde, mittels der Steuereinheit zweckmäßigerweise die Halbleiterschalter derart angesteuert, dass der Strompfad unterbrochen wird. Die Stromstärke ist dabei insbesondere größer als eine Nenn-Stromstärke des Schutzschalters. Dabei wird insbesondere zunächst zumindest einer der Halbleiterschalter geöffnet, also in den elektrisch nichtleitenden Zustand versetzt, sodass der elektrische Strom zum Erliegen kommt. Dabei ist es möglich, dass in eine der Stromrichtungen für eine längerer Zeitdauer als in die andere Stromrichtungen die gleiche Stromstärke geführt wird, bis das Unterbrechen des Strompfads erfolgt.

Aufgrund einer derartigen Ausgestaltung des Schutzschalters ist es somit möglich, mittels dessen gezielt auf einem Fehlerfall einer damit bestromten Last, wie einem Aktor, zu überwachen, insbesondere einen Kurzschluss bei dieser Last. Hierbei wird bei einem Kurzschluss der elektrische Strom über den Schutzschalter lediglich in eine der beiden Stromrichtungen geführt. Falls der elektrische Strom in die entgegengesetzte Stromrichtung auftritt, wird dieser somit nicht von einem Kurzschluss bei der Last hervorgerufen. Insbesondere wird in diesem Fall der Schalter nicht betätigt. Somit ist es möglich, für die jeweilige Last, die mittels des Schutzschalters abgesichert wird, die Zeit-Strom-Auslösekennlinie derart anzupassen, sodass eine Überlastung oder Beschädigung der Last vermieden wird. Die Stromrichtung ist dabei auf den Aktor zugerichtet

In die entgegengesetzte Stromrichtung hingegen ist die Zeit-Strom-Auslösekennlinie derart angepasst, dass eine Beschädigung des etwaigen Gleichspannungszwischenkreises vermieden ist. Dabei ist zweckmäßigerweise ein größerer elektrischer Stromfluss von der Last in den Gleichspannungszwischenkreises oder ein die Last bestromendes Versorgungsnetz oder dergleichen ermöglicht, ohne dass ein Unterbrechen des Strompfads erfolgt. Somit ist der Aktor weiterhin betriebsfähig, zumal dieser keine Fehlfunktion aufweist. Alternativ oder in Kombination hierzu ist der Schutzschalter beispielsweise einer Batterie zugeordnet. Mittels Anpassung der Zeit-Strom-Auslösekennlinie ist es dabei möglich, einen höheren Ladestrom als einen Entladestrom zuzulassen, ohne dass ein Unterbrechen des Strompfads erfolgt.

Insbesondere wird der Schutzschalter in einem Gleichspannungskreis eingesetzt, also zum Beispiel zwischen einer Last und einem Gleichspannungszwischenkreis oder dergleichen. Hierbei ist insbesondere die Zeit-Strom-Auslösekennlinie für einen Stromfluss von dem Gleichspannungszwischenkreis zu der Last auf die verwendete Last angepasst, sodass bei einem Fehlerfall der Last, wie dem Kurzschluss, der Stromfluss zu der Last unterbrochen wird. Bei der entgegengesetzten Stromflussrichtung hingegen ist insbesondere die Zeit-Strom-Auslösekennlinie auf den Gleichspannungszwischenkreis oder sonstiger Bestandteile der jeweiligen Anlage, in der die Last verwendet wird, angepasst, sodass diese ebenfalls geschützt ist.

Vorzugsweise liegt hierbei im Gleichspannungskreis eine elektrische Gleichspannung zwischen 400 V und 650 V an, also insbesondere höherer Gleichspannung. Vorzugsweise wird der Schutzschalter zur Absicherung eines Aktors bei einer Industrieanlage verwendet. Der Aktor bildet hierbei insbesondere die Last. Aufgrund der verringerten Anzahl an nicht erforderlichen Auslösungen, also Betätigung des Schutzschalters, nämlich dem Unterbrechen des Strompfads, ist die Anzahl an Ausfällen reduziert, weswegen Betriebskosten verringert sind. Zweckmäßigerweise wird der Schutzschalter im Bereich der Industrieautomation verwendet. Insbesondere ist die mittels des Schutzschalters geschaltete elektrische Spannung 24 V, 48 V, 380 V, 650 V, 760 V. Bei einer Alternative wird der Schutzschalter zur Absicherung einer Straßenbeleuchtung, eines Schiffsbordnetzes, Bahnanwendungen-Infrastruktur, Bahnanwendungen-Antrieb oder im Bereich der elektrifizierten Luftfahrt verwendet. Bei einer weiteren Alternative wird der Schutzschalter im Ausbau und Integration erneuerbarer Energieerzeuger, bei Inselnetzen, im privaten häuslichen Bereich, in Gewächshäusern, bei der Elektrifizierung straßengebundener Mobilität (Elektromobilität), Landwirtschaft oder bei, Baustellenfahrzeugen verwendet. Die verwendet elektrische (Gleich-)Spannung ist dabei zum Beispiel zwischen 1500 V und 3000 V oder beträgt 110 V, 380 V, 400 V 800 V, 1000 V 1500 V, 3000 V. Zusammenfassend wird alternativ zur Anwendung bei einer Industrieanlage der Schutzschalter beispielsweise bei einem Elektrofahrzeug verwendet, wie einem Kraftfahrzeug, einem Flugzeug oder einem Schiff/Boot.

Aufgrund der beiden Halbleiterschalter ist beispielsweise ein Schaltvermögen vergrößert, und zum Beispiel sind die beiden Halbleiterschalter derart ausgebildet, dass mittels jedes davon der elektrische Stromfluss in beide Stromrichtung unterbrochen werden kann. Alternativ hierzu ist mittels jedes lediglich das Unterbrechen des elektrischen Stroms in eine der beiden Stromrichtungen ermöglicht. Da die beiden Halbleiterschalter gegengesetzt zueinander geschaltet sind, ist dabei dennoch ein Unterbrechen des elektrische Stromfluss über den ersten Zweig mittels beider Halbleiterschalter möglich. Beispielsweise unterscheiden sich die Halbleiterschalter, insbesondere in Abhängigkeit der maximal schaltbaren elektrische Schaltung. Somit ist es beispielsweise möglich, bei einem vorwiegenden Betrieb in eine der Stromrichtungen einen Halbleiterschalter mit einem vergleichsweise hohen Schaltvermögen und für die andere Stromrichtung einen Halbleiterschalter mit einem geringeren Schaltvermögen zu verwenden, zumindest wenn die Zeit-Strom-Auslösekennlinie entsprechend angepasst ist. Infolgedessen sind Herstellungskosten reduziert. Besonders bevorzugt jedoch sind die beiden Halbleiterschalter zueinander baugleich. Somit können Gleichteile verwendet werden. Auch ist bei Montage des Schutzschalters, mit Ausnahme der Anpassung der Zeit-Strom-Auslösekennlinie, auf keine besondere Einbaulage zu achten.

Die Einheit weist vorzugsweise einen Sensor auf, beispielsweise einen Stromsensor. Mittels dessen wird beispielsweise ein den Strompfad umgebendes Magnetfeld erfasst, insbesondere mittels eines Hall-Sensors, und anhand dessen wird zum Beispiel der geführte elektrische Strom ermittelt. Dies ist berührungslos möglich, sodass insbesondere eine galvanische Trennung realisiert ist. Besonders bevorzugt jedoch umfasst die Einheit einen Shunt. Dieser umfasst einen Messwiderstand, wobei zum Ermitteln des geführten elektrischen Stroms die über den Shunt abfallende elektrische Spannung gemessen wird. Somit sind Herstellungskosten reduziert.

Beispielsweise sind die Sensoren der Einheit jeweils derart ausgebildet, dass mittels dieser der Stromfluss in beide Stromrichtungen gemessen/erfasst werden kann. Alternativ hierzu weist die Einheit zwei Untereinheiten auf, die insbesondere elektrisch in Reihe geschaltet sind. Hierbei ist mittels einer der Untereinheiten das Ermitteln des elektrischen Stroms in die eine Stromrichtung und mittels der anderen Untereinheiten das Ermitteln des elektrischen Stroms in die andere Stromrichtung ermöglicht. Somit sind Anforderungen an den jeweiligen Sensor verringert, weswegen die Einheit vergleichsweise kostengünstig ausgebildet werden kann, auch wenn zwei Untereinheiten erforderlich sind.

Beispielsweise sind die beiden Halbleiterschalter mittels der Steuereinheit separat betätigt. Auf diese Weise ist es beispielsweise möglich, gezielt einen Rückstrom zuzulassen, oder die Halbleiterschalter in einer bestimmten zeitlichen Reihenfolge zu betätigen. Besonders bevorzugt jedoch sind die Steuereingänge der Halbleiterschalter elektrisch kurzgeschlossen, also niederohmig miteinander elektrisch kontaktiert. Somit ist sichergestellt, dass beide Halbleiterschalter stets gleichzeitig betätigt werden und den gleichen Schaltzustand aufweisen, also geöffnet oder geschlossen sind. Auch kommt dann bei einem Öffnen der Halbleiterschalter der elektrische Stromfluss über den Strompfad vollständig zum Erliegen. Daher ist ein elektrischer Stromfluss in die entgegengesetzte Stromrichtung ebenfalls nicht möglich, wenn der in eine der Stromrichtungen der elektrische Strom mit einer bestimmten Stromstärke für die zugeordnete Zeitdauer geführt wurde. Ferner ist aufgrund des Kurzschlusses eine elektrische Schaltung vereinfacht.

Beispielsweise umfasst der Strompfad lediglich den ersten Zweig und ist insbesondere mittels dessen gebildet. Besonders bevorzugt jedoch ist elektrisch parallel zu dem ersten Zweig ein zweiter Zweig geschaltet. Der zweite Zweig umfasst ebenfalls zwei elektrisch in Reihe und entgegengesetzt zueinander geschaltete Halbleiterschalter, die jeweils einen Steuereingang aufweisen und auch mittels der Steuereinheit betrieben sind. Dabei werden die beiden Halbleiterschalter des zweiten Zweigs zweckmäßigerweise ebenfalls anhand der gleichen Zeit-Strom-Auslösekennlinie betrieben. Aufgrund des zweiten Zweigs ist somit der elektrische Strom verringert, der mittels jedes der Halbleiterschalter geführt wird, weswegen vergleichsweise kostengünstige Halbleiterschalter verwendet werden können. Beispielsweise sind die Halbleiterschalter des zweiten Zweigs zueinander unterschiedlich oder zweckmäßigerweise zueinander baugleich. Vorzugsweise sind die Halbleiterschalter des zweiten Zweigs baugleich zu den Halbleiterschaltern des ersten Zweigs. Somit können Gleichteile verwendet werden, und bei Herstellung ist eine Lagerhaltung vereinfacht. Insbesondere sind der erste und der zweite Zweig zueinander baugleich ausgestaltet, also vorzugsweise (punkt-)symmetrisch. Infolgedessen erfolgt eine gleichmäßige Aufteilung des geführten elektrischen Stroms auf die beiden Zweige, weswegen eine übermäßige Belastung eines der beiden Zweige ausgeschlossen ist.

Beispielsweise sind die Steuereingänge der beiden Halbleiterschalter des zweiten Zweigs elektrisch kurzgeschlossen. Somit werden die Halbleiterschalter des zweiten Zweigs stets gleichzeitig betätigt. Beispielsweise sind dabei die Halbleiterschalter des ersten Zweigs und des zweiten Zweigs unabhängig voneinander betreibbar. Somit ist es möglich, über einen der beiden Zweige den elektrischen Strom in zuzulassen, und über den andere nicht. Besonders bevorzugt jedoch ist der Steuereingang eines der beiden Halbleiterschalter des ersten Zweigs und der Steuereingang eines der beiden Halbleiterschalter des zweiten Zweigs elektrisch kurzgeschlossen. Somit werden diese ebenfalls stets gleichzeitig geschaltet, was die elektrische Verschaltung vereinfacht. Insbesondere sind dabei jeweils die Steuereingänge derjenigen Halbleiterschalter elektrisch kurzgeschlossen, die der gleichen Stromrichtung zugeordnet sind, weswegen der elektrische Stromfluss in die entsprechende Stromrichtung stets vollständig unterbrochen werden kann.

Besonders bevorzugt sind alle Steuereingänge elektrisch kurzgeschlossen. Infolgedessen werden sämtliche Halbleiterschalter stets gleich betrieben, also beispielsweise in den elektrisch leitfähigen oder elektrisch nicht leitfähigen Zustand versetzt. Auf diese Weise ist eine elektrische Verschaltung vereinfacht und eine Fehleranfälligkeit reduziert. Zudem wird auf diese Weise stets sichergestellt, dass, wenn in die der Stromrichtungen die Stromstärke des elektrischen Stroms größer als die zugeordnete Zeitdauer ist und somit der Strompfad unterbrochen wird, auch kein Rückstrom auftritt, also ein elektrischer Strom in die entgegengesetzte Stromrichtung. Somit ist beispielsweise bei einem Defekt des mittels des Schutzschalters abgesicherten Aktors dieser vollständig stromlos, weswegen eine Sicherheit erhöht ist.

Beispielsweise ist die Einheit einem von den Zweigen separaten Bereich des Strompfads zugeordnet, weswegen mittels dieser sicher der vollständige elektrische Strom erfasst werden kann. Alternativ ist die Einheit lediglich einem der beiden Zweige zugeordnet. Hierbei sind die beiden Zweige, insbesondere mit Ausnahme der Einheit, vorzugsweise zueinander baugleich ausgebildet oder weisen zumindest den gleichen elektrischen Widerstand auf. Infolgedessen teilt sich der elektrische Strom auf die beiden Zweige gleichmäßig auf, und der mittels der Einheit ermittelte elektrische Strom beträgt der Hälfte des mittels des Strompfads geführten elektrischen Stroms. Besonders bevorzugt umfasst die Einheit die beiden Untereinheiten, wobei mittels jeder Untereinheit lediglich der in eine der Stromrichtungen geführt elektrische Strom ermittelt werden kann, insbesondere gemessen/erfasst. Hierbei sind die beiden Untereinheiten beispielsweise einem der beiden Zweige zugeordnet. Vorzugsweise jedoch ist jedem der Zweige jeweils eine der Untereinheiten zugeordnet, die insbesondere zueinander antiparallel orientiert sind, dass der elektrische Strom in beide Stromrichtungen ermittelt werden, nämlich jeweils stets dessen Hälfte erfasst werden kann. Insbesondere sind somit die beiden Zweige antiparallel oder punktsymmetrisch zueinander aufgebaut. Somit ist der elektrische Strom, der von jeder Untereinheit geführt wird vergleichsweise gering. Auch sind die beiden Zweige zueinander baugleich, jedoch unterschiedliche orientiert. Somit können diese als Modul bereitgestellt werden, was Herstellungskosten reduziert.

Beispielsweise ist der vollständige Schutzschalter frei von mechanischen Schaltern. Besonders bevorzugt jedoch ist elektrischen Reihe mit dem ersten Zweig ein mechanischer Schalter geschaltet. Sofern der zweite Zweig ebenfalls vorhanden ist, ist dieser ebenfalls elektrisch in Reihe mit dem mechanischen Schalter geschaltet. Der mechanische Schalter ist vorzugsweise ein Bestandteil eines Relais, das einen Antrieb umfasst. Vorzugsweise ist das Relais, also der Antrieb, mittels der Steuereinheit betrieben. Aufgrund des mechanischen Schalters ist es möglich, die beiden Anschlüsse zueinander galvanisch zu trennen, was eine Sicherheit erhöht. Zweckmäßigerweise erfolgt mittels der Steuereinheit zunächst ein Unterbrechen eines elektrischen Stromfluss mittels der Halbleiterschalter und dann wird der mechanische Schalter geöffnet, was lichtbogenfrei erfolgt. Bei einem Versetzen in den elektrisch leitfähigen Zustand hingegen wird zweckmäßigerweise zunächst der mechanische Schalter und anschließend die Halbleiterschalter in den elektrisch leitfähigen Zustand versetzt. Somit ist auch dort ein Ausbilden eines Lichtbogens vermieden. Vorzugsweise ist die Steuereinheit entsprechend ausgebildet. Zum Beispiel umfasst der mechanische Schalter einen einfachen Bewegkontakt oder zweckmäßigerweise einen Doppelkontakt, weswegen die mittels jedes Kontakts geschaltete elektrische Spannung verringert ist, was eine erforderliche Lichtbogenspannung erhöht.

Ein Schutzschalter mit zwei Anschlüssen, zwischen denen ein Strompfad gebildet ist, zur Absicherung einer Last in einem Gleichspannungskreis verwendet. Dabei weist der Schutzschalter eine Einheit zum richtungsabhängigen Ermitteln eines mittels des Strompfads geführten elektrischen Stroms auf, die dem Strompfad zugeordnet ist. Der Strompfad weist eine ersten Zweig mit zwei elektrisch in Reihe und gegengesetzt zueinander geschalteten Halbleiterschalter auf, die jeweils einen Steuereingang umfassen und mittels einer Steuereinheit entsprechend einer Zeit-Strom-Auslösekennlinie betrieben sind. Mittels der Zeit-Strom-Auslösekennlinie sind für unterschiedliche Stromstärken zumindest teilweise sich unterscheidende Zeitdauern angegeben, ab der ein Unterbrechen des Strompfads erfolgt, wobei sich zumindest einige der Zeitdauern für unterschiedliche Stromrichtungen unterscheiden.

Zweckmäßigerweise umfasst der Gleichspannungskreis mehrere derartige Lasten, die insbesondere elektrisch parallel zueinander geschaltet sind. Aufgrund der Schutzschalter wird somit vermieden, dass bei einem Kurzschluss einer der Lasten, die Schutzschalter, die den anderen Lasten zugeordnet sind, betätigt werden. Insbesondere betrifft die Erfindung auch einen derartigen Gleichspannungskreis, der insbesondere ein Bestandteil einer Industrieanlage ist. In diesem Fall bildet die Last oder einige der Lasten einen Aktor, mittels dessen beispielsweise eine Bearbeitung und/oder Erstellung eines Werkstücks erfolgt.

Die im Zusammenhang mit dem Schutzschalter erläuterten Weiterbildungen und Vorteile sind sinngemäß auch auf die Verwendung / den Gleichspannungskreis sowie untereinander zu übertragen und umgekehrt.

Nachfolgend wird ein Ausführungsbeispiel der Erfindung anhand einer Zeichnung näher erläutert. Darin zeigen:
- Fig. 1: schematisch einen Gleichspannungskreis mit zwei Lasten, denen jeweils ein Schutzschalter zugeordnet ist,
- Fig. 2: schematisch vereinfacht einen Schaltplan des Schutzschalters, und
- Fig. 3: schematisch eine Zeit-Strom-Auslösekennlinie.

Einander entsprechende Teile sind in allen Figuren mit den gleichen Bezugszeichen versehen.

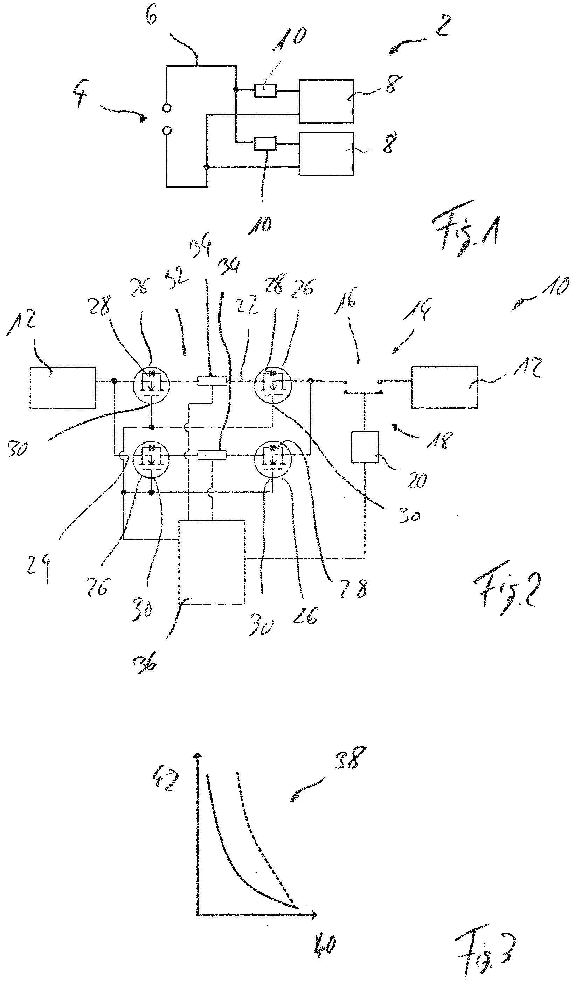

In Figur 1 ist schematisch vereinfacht ein Gleichspannungskreis 2 dargestellt, der eine Gleichspannungsquelle 4 umfasst. Mittels dieser wird eine elektrische Gleichspannung von 650 V bereitgestellt, und mittels dieser ist ein Gleichspannungszwischenkreis 6 gespeist. Mittels dessen werden zwei Lasten 8 versorgt, die zueinander parallelgeschaltet und gegen den Gleichspannungszwischenkreis 6 über jeweils einen Schutzschalter 10 geführt sind, die zueinander baugleich sind.

In Figur 2 ist ein schematisch vereinfachter Schaltplan des Schutzschalters 10 dargestellt. Der Schutzschalter 10 weist zwei Anschlüsse 12 auf, zwischen denen ein Strompfad 14 gebildet ist. Dabei ist einer der Anschlüsse 12 gegen den Gleichspannungszwischenkreis 6 und der andere gegen die jeweils zugeordnete Last 8 geführt. Der Strompfad 14 weist einen mechanischen Schalter 16 auf, der als ein Relais 18 ausgebildet ist. Dieses weist ein Antrieb 20 auf, mittels dessen der mechanischen Schalter 16 angetrieben ist, der als Doppelunterbrecher oder Doppelkontakt ausgebildet ist.

Ferner weist der Strompfad 14 einen ersten Zweig 2 20 und einen zweiten Zweig 24 auf, die jeweils elektrisch in Reihe zu dem mechanischen Schalter 16 geschaltet sind. Der erste Zweig 22 und der zweite Zweig 24 sind zueinander baugleich und elektrisch parallelgeschaltet. Die beiden Zweige 22, 24 sind antiparallel zueinander angeordnet. Mit anderen Worten ist einer der beiden Zweige 22, 24 bezüglich des jeweils anderen Zweigs 22, 24 um 180° gedreht angeordnet.

Jeder Zweig 22, 24 weist jeweils zwei zueinander baugleiche Halbleiterschalter 26 auf, die als MOSFET ausgebildet sind. Somit weist jeder Halbleiterschalter 26 eine Freilaufdiode 28 auf. Die Halbleiterschalter 26 jedes Zweigs 22, 24 sind elektrisch in Reihe und entgegengesetzt zueinander geschaltet, sodass die Sperrrichtungen der jeweils zugeordneten Freilaufdioden 28 entgegengesetzt zueinander angeordnet sind. In der dargestellten Variante sind die Kollektoren ("Drain") der Halbleiterschalter 26 jedes Zweigs 22, 24 einander zugewandt, sodass ich um eine "common drain"-Verschaltung handelt. Die im Emitter ("Source") der Halbleiterschalter 26 jedes Zweigs 22, 24 sind gegen einen der Anschlüsse 12 bzw. den mechanischen Schalter 26 geführt. Auch sind somit die Ermittler der Halbleiterschalter 26 des ersten Zweigs 22 mit dem Emitter jeweils eines der Halbleiterschalter 26 des zweiten Zweigs 24 elektrisch verbunden.

Jeder Halbleiterschalter 26 weist ferner einen Steuereingang 30 (Basis, "Gate") auf, die alle miteinander elektrisch kontaktiert sind. Dabei sind alle Steuereingänge 30 elektrisch kurzgeschlossen. Folglich sind die Steuereingänge 30 der beiden Halbleiterschalter 26 jedes Zweigs 20, 24 elektrisch kurzgeschlossen, und jeweils der Steuereingang 30 eines der beiden Halbleiterschalter 26 des ersten Zweigs 22 und der Steuereingang 30 eines der beiden Halbleiterschalter 26 des zweiten Zweigs 24 sind elektrisch kurzgeschlossen. Zusammenfassend weist somit der Strompfad 14 den ersten Zweig 22 und den zweiten Zweig 24 auf, die zueinander parallelgeschaltet sind, und die jeweils die zugeordneten beiden Halbleiterschalter 26 aufweisen, die elektrisch in Reihe und entgegengesetzt zueinander geschaltet sind.

Der Schutzschalter 10 weist ferner eine Einheit 32 zum richtungsabhängigen Ermitteln des mittels des Strompfads 14 geführten elektrischen Stroms auf, die dem Strompfad 14 zugeordnet ist. Die Einheit 32 weist zwei zueinander baugleiche Untereinheiten 34 auf, die den unterschiedlichen Zweigen 22, 24 zugeordnet sind. Da die beiden Zweige 22, 24 zueinander baugleich sind, wird der mittels des Strompfads 14 geführte elektrische Strom symmetrisch auf beide Zweige 22, 44 aufgeteilt.

Die Untereinheiten 34 weisen einen Shunt auf, der einen Messwiderstand umfasst, der in den jeweiligen Zweig 22, 24 eingebracht ist. Ferner umfasst jede Untereinheit 34 einen Operationsverstärker, mittels dessen die über den jeweiligen Messwiderstand anfallende elektrische Spannung gemessen werden kann. Anhand der elektrischen Spannung sowie des bekannten ohmschen Widerstands des Messwiderstands ist es möglich, den elektrischen Strom zu ermitteln. Die Verschaltung des Operationsverstärkers ist dabei derart, dass lediglich eine Polarität der die elektrischen Spannung gemessen werden kann. Bei einer entgegengesetzten Polarität, die zu einem entgegengesetzten Stromfluss korrespondiert, ist das Messen nicht möglich. Infolgedessen sind Herstellungskosten vergleichsweise gering.

Da die beiden Zweige 22, 24 antiparallel zueinander angeordnet sind, sind auch die Stromrichtungen, für die mittels der jeweiligen Untereinheit 34 der elektrische Strom ermittelt werden kann, unterschiedlich. Somit kann mittels der Einheit 32 richtungsabhängige der mittels des Strompfads 14 geführte elektrische Strom ermittelt werden, der dem Doppelten des mittels derjenigen Untereinheiten 34 ermittelten elektrischen Stroms entspricht, bei der die gemessene elektrische Spannung verschieden von 0 V ist. Falls bei beiden Untereinheiten 34 die elektrische Spannung 0 V ist, ist der mittels des Strompfads 14 geführte elektrische Strom 0 A.

Bei einer nicht näher dargestellten Variante weist jede der Untereinheiten 34 einen Stromsensor auf, mittels derer ebenfalls jeweils lediglich der in eine der Stromrichtungen geführte Strom ermittelt werden kann.

Zusammenfassend weist die Einheit 32 die beiden Untereinheiten 34 auf, mittels derer jeweils lediglich der in der Stromrichtungen geführte elektrisch Strom ermittelt werden kann, wobei jedem Zweig 22, 24 jeweils eine der Untereinheiten 34 zugeordnet ist. Dabei sind die beiden Untereinheiten 34 zueinander antiparallel angeordnet.

Das Ermitteln des elektrischen Stroms erfolgt mittels einer Steuereinheit 36, die mit jeder der Untereinheiten 34 signaltechnisch verbunden ist. Mittels der Steuereinheit 36 wird somit die jeweils anliegende elektrische Spannung ausgelesen und anhand des bekannten ohmschen Widerstands der mittels des jeweiligen Zweigs 22, 44 geführte elektrische Strom ermittelt und verdoppelt. Somit ist in der Steuereinheit 36 das Wissen vorhanden, wie hoch der mittels des Strompfads 14 geführte elektrische Strom ist, und in welche Stromrichtung der elektrische Strom fließt.

Die Steuereinheit 36 weist einen nicht näher dargestellten Mikrocontroller auf und ist auch mit dem Antrieb 20 verbunden, weswegen das Relais 18 mittels der Steuereinheit 36 betrieben ist. Auch sind die miteinander kurzgeschlossen Steuereingänge 30 aller Halbleiterschalter 26 mit der Steuereinheit 36 signaltechnisch verbunden, sodass alle Halbleiterschalter 26 mittels der Steuereinheit 36 betrieben sind. Dabei werden mittels der Steuereinheit 36 sämtliche Halbleiterschalter 26 entweder in den elektrisch leitenden oder in den elektrisch nichtleitenden Zustand versetzt.

Die Halbleiterschalter 26 sind mittels der Steuereinheit 36 entsprechend einer in Figur 3 dargestellten Zeit-Strom-Auslösekennlinie 38 betrieben. In dem Graphen sind in doppelt logarithmische Darstellung auf der x-Achse eine Stromstärke 40 und auf der y-Achse eine Zeitdauer 42 aufgetragen. Die Stromstärke 40 ist stets positiv und somit der Betrag eines elektrischen Stroms.

Die Zeit-Strom-Auslösekennlinie 38 weist zwei Zweige auf, die jeweils zumindest abschnittsweise hyperbelförmig sind, und die sich zumindest abschnittsweise unterscheiden. Somit ist mittels der Zeit-Strom-Auslösekennlinie 38 jeder Stromstärke 40, die größer als eine Nenn-Stromstärke des Schutzschalters 10 ist, zumindest eine oder zwei Zeitdauern 42 zugeordnet, die sich dann unterscheiden. Hierbei ist einer der Zweige der Zeit-Strom-Auslösekennlinie 38 dem elektrischen Strom in die eine Stromrichtung und der andere Zweig dem elektrischen Strom in die andere Stromrichtung über den Strompfad 14 zugeordnet. Somit unterscheiden sich zumindest einige der Zeitdauern 42 für unterschiedliche Stromrichtung, bei einigen der Stromstärken 40. Bei einem Zweig wird dabei zum Beispiel bei der dem Doppelten der Nenn-Stromstärke entsprechenden Stromstärke 40 die Zeitdauer 42 von 20ms und bei der dem Vierfachen der Nenn-Stromstärke entsprechenden Stromstärke 40 die Zeitdauer 42 von 10 ms zugeordnet. Bei dem anderen Zweig wird dann bei der dem Doppelten der Nenn-Stromstärke entsprechenden Stromstärke 40 die Zeitdauer 42 von 1 s und bei der dem Vierfachen der Nenn-Stromstärke entsprechenden Stromstärke 40 die Zeitdauer 42 von 100 ms zugeordnet.

Wenn mittels des Strompfads 14 der elektrische Strom mit der der jeweiligen Stromstärke 40 zugeordneten Zeitdauer 42 geführt wurde, also wenn die entsprechende Zeitdauer 42 erreicht wird, wird der Strompfad 14 unterbrochen. Hierfür werden die Halbleiterschalter 26 in den elektrisch nichtleitenden Zustand versetzt. Danach wird das Relais 18 betrieben, sodass der mechanische Schalter 16 geöffnet wird. Infolgedessen sind die beiden Anschlüsse 12 zueinander galvanisch getrennt.

In einem Normalbetrieb, also wenn die Last 8 in gewünschter Art und Weise bestromt wird, fließt der elektrische Strom von dem Gleichspannungszwischenkreis 6 über den elektrisch leitenden Schutzschalter 10 zu der Last 8. elektrische Strom wird dabei mittels des mechanischen Schalters 26 sowie der Halbleiterschalter 26 geführt. Sofern die Last 8 ordnungsgemäß arbeitet, ist die Stromstärke 40 gleich der Nenn-Stromstärke oder geringer. Falls jedoch ein Fehlerfall der Last 8 vorliegt, beispielsweise ein Kurzschluss, steigt die Stromstärke 40 vergleichsweise stark an, was mittels der Einheit 32 ermittelt wird. Wenn dies für die zugeordnete Zeitdauer 42 anhält, wird der Schutzschalter 10 in den elektrisch nichtleitenden Zustand versetzt, wofür die Halbleiterschalter 26 und das Relais 18 entsprechend angesteuert werden.

Bis der Schutzschalter 10 in den elektrisch nichtleitenden Zustand versetzt wird, ist jedoch bei der den Kurzschluss aufweisenden Last 8, die im Weiteren auch als defekte Last 8 bezeichnet wird, eine niederohmige Verbindung vorhanden. Infolgedessen ist es möglich, dass von einer Kapazität oder einem sonstigen Energiespeicher der noch funktionierenden Last 8 ebenfalls ein elektrischer Stromfluss zu der defekten Last 8 einsetzt. Somit wird mittels des der funktionierenden Last 8 zugeordneten Schutzschalters 10 ebenfalls ein vergleichsweiser hoher elektrischer Strom geführt, obwohl die Last 8 keine Fehlfunktion aufweist. Dabei ist jedoch die Stromrichtung entgegengesetzt zu der Stromrichtung im Normalbetrieb.

Der dieser Stromrichtung zugeordnete Zweig der Zeit-Strom-Auslösekennlinie 38 ist dabei derart gewählt, dass die Halbleiterschalter 26 auch weiterhin in dem elektrisch leitenden Zustand verbleiben. Somit ist nach dem Abtrennen der defekten Last 8 von dem Gleichspannungszwischenkreis 6 mittels des zugeordneten Schutzschalters 10 auch weiterhin ein Betrieb der funktionellen Last 8 möglich. Zusammenfassend wird jeder Schutzschalter 10 zur Absicherung der jeweiligen Last 8 im Gleichspannungskreis einer der Lasten 8 im Gleichstromkreis 2 verwendet.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebene Einzelmerkmale auch auf andere Weise miteinander kombinierbar, ohne den Gegenstand der Erfindung zu verlassen.

### Bezugszeichenliste

- 2: Gleichspannungskreis
- 4: Gleichspannungsquelle
- 6: Gleichspannungszwischenkreis
- 8: Last
- 10: Schutzschalter
- 12: Anschluss
- 14: Strompfad
- 16: mechanischer Schalter
- 18: Relais
- 20: Antrieb
- 22: erster Zweig
- 24: zweiter Zweig
- 26: Halbleiterschalter
- 28: Freilaufdiode
- 30: Steuereingang
- 32: Einheit
- 34: Untereinheit
- 36: Steuereinheit
- 38: Zeit-Strom-Auslösekennlinie
- 40: Stromstärke
- 42: Zeitdauer

## Patentansprüche

1. Schutzschalter (10) mit zwei Anschlüssen (12), zwischen denen ein Strompfad (14) gebildet ist, dem eine Einheit (32) zum richtungsabhängigen Ermitteln eines mittels des Strompfads (14) geführten elektrischen Stroms zugeordnet ist, und der einen ersten Zweig (22) mit zwei elektrisch in Reihe und gegengesetzt zueinander geschalteten Halbleiterschalter (26) aufweist, die jeweils einen Steuereingang (30) umfassen und mittels einer Steuereinheit (36) entsprechend einer Zeit-Strom-Auslösekennlinie (38) betrieben sind, mittels derer für unterschiedliche Stromstärken (40) zumindest teilweise sich unterscheidende Zeitdauern (42) angegeben sind, ab der ein Unterbrechen des Strompfads (14) erfolgt, und wobei sich zumindest einige der Zeitdauern (42) für unterschiedliche Stromrichtungen unterscheiden.

2. Schutzschalter (10) nach Anspruch 1,
**dadurch gekennzeichnet,**
**dass** die Steuereingänge (30) der beiden Halbleiterschalter (26) elektrisch kurzgeschlossen sind.

3. Schutzschalter (10) nach Anspruch 1 oder 2,
**dadurch gekennzeichnet,**
**dass** elektrisch parallel zu dem ersten Zweig (22) ein zweiter Zweig (24) geschaltet ist, der zwei elektrisch in Reihe und gegengesetzt zueinander geschaltete Halbleiterschalter (26) aufweist, die jeweils einen Steuereingang (30) aufweisen und mittels der Steuereinheit (36) betrieben sind.

4. Schutzschalter (10) nach Anspruch 3,
**dadurch gekennzeichnet,**
**dass** jeweils der Steuereingang (30) eines der beiden Halbleiterschalter (26) des ersten Zweigs (22) und der Steuereingang (30) eines der beiden Halbleiterschalter (24) des zweiten Zweigs (24) elektrisch kurzgeschlossen sind.

5. Schutzschalter (10) nach Anspruch 4,
**dadurch gekennzeichnet,**
**dass** alle Steuereingänge (30) elektrisch kurzgeschlossen sind.

6. Schutzschalter (10) nach einem der Ansprüche 3 bis 5,
**dadurch gekennzeichnet,**
**dass** die Einheit (32) zwei Untereinheiten (34) aufweist, mittels derer jeweils lediglich der in eine der Stromrichtungen geführte Strom ermittelt werden kann, wobei jedem Zweig (2, 24) jeweils eine der Untereinheiten (34) zugeordnet ist.

7. Schutzschalter (10) nach einem der Ansprüche 1 bis 6,
**dadurch gekennzeichnet,**
**dass** elektrisch in Reihe mit dem ersten Zweig (22) ein mechanischer Schalter (16) geschaltet ist.

8. Verwendung eines Schutzschalters (10) nach einem der Ansprüche 1 bis 7 zur Absicherung einer Last (8) in einem Gleichspannungskreis (2).
